# EUROPÄISCHE PATENTSCHRIFT

(11) **EP 0 458 163 B1**
(45) Veröffentlichungstag und Bekanntmachung des Hinweises auf die Patenterteilung: **20.12.1995**
(21) Anmeldenummer: 91107731.1
(22) Anmeldetag: 13.05.1991
(51) Int. Cl.: H05K 3/34, B23K 1/008

(54) **Verfahren und Einrichtung zum Reflow-Löten von Elektronik-Bauteilen auf eine Leiterplatte**
Method and apparatus for reflow-soldering of electronic devices on a circuit board
Procédé et dispositif pour la soudure à reflux des éléments électroniques sur une plaquette à circuits imprimés

(30) Priorität: 21.05.1990 DE 4016366
(43) Veröffentlichungstag der Anmeldung: 27.11.1991
(73) Patentinhaber: Systronic Maschinenbau GmbH, 74223 Flein (DE)
(72) Erfinder: Volk, Helmut, W-4790 Paderborn (DE)
(74) Vertreter: Schaumburg, Thoenes, Thurn Patentanwälte

(56) Entgegenhaltungen:
- EP-A- 0 251 257
- EP-A- 0 325 451
- WO-A-89/01283
- GB-A- 2 063 925
- PATENT ABSTRACTS OF JAPAN, Bd. 14, Nr. 297 (E-945)27. Juni 1990;& JP-A-2096394
- PATENT ABSTRACTS OF JAPAN, Bd. 11, Nr. 64 (M-565)26. Februar 1987;& JP-A-61222674
- PATENT ABSTRACTS OF JAPAN, Bd. 15, Nr. 143 (E-1054)11. April 1991;& JP-A-3021096

## Beschreibung

Die vorliegende Erfindung betrifft ein Verfahren zum Reflow-Löten von Elektronik-Bauteilen auf eine Leiterplatte gemäß dem Oberbegriff des Anspruches 1 sowie eine Einrichtung zur Durchführung dieses Verfahrens gemäß dem Oberbegriff des Anspruches 10.

Beim Reflow-Löten wird auf die Leiterplatten an den Stellen, die ein Elektronik-Bauteil aufnehmen sollen, Lotmaterial aufgetragen. Auf das im festen Zustand befindliche Lotmaterial werden die Bauteile aufgelegt. Sodann werden die mit den Bauteilen bestückten Leiterplatten erwärmt, bis das Lotmaterial schmilzt, und anschließend wieder abgekühlt, wobei das Lotmaterial erstarrt. Bei diesem Verfahren werden auch die Elektronik-Bauteile auf verhältnismäßig hohe Temperaturen erwärmt, damit sich das Lotmaterial mit den Bauteilen verbindet. Um die Wärmebelastung der Bauteile gering zu halten, werden bei bekannten Verfahren die bestückten Leiterplatten zunächst in einer Vorwärmzone auf eine unter der Schmelztemperatur des Lotmaterials liegende Vorwärmtemperatur erwärmt und anschließend kurzzeitig einer Temperatur ausgesetzt, bei der das Lotmaterial schmilzt (EP 0 325 451 A1). Dabei werden die Leiterplatten mit einer Transporteinrichtung kontinuierlich durch die Vorwärmzone und anschließend durch die Lötzone hindurch bewegt.

Die Temperaturregelung erfolgt dabei jeweils über die Regelung der Heizleistung in den einzelnen Zonen, die so gewählt wird, daß bei der durch die Transportgeschwindigkeit vorgegebenen Einwirkungszeit in der Vorwärmzone einerseits und der Lötzone andererseits die gewünschten Temperaturen erreicht werden.

Es hat sich gezeigt, daß diese Regelung nicht optimal ist, da einerseits eine feine Abstufung der Heizleistung technisch sehr aufwendig ist und andererseits die Temperaturregelung über eine Änderung der Heizleistung verhältnismäßig träge arbeitet.Da die Einwirkungszeiten in den beiden Zonen vorgegeben und über die Fördergeschwindigkeit der Transporteinrichtung voneinander abhängig sind, muß die Heizleistung in den jeweiligen Zonen so gewählt werden, daß in jeder dieser Zonen die verfahrenstechnisch erforderlichen Temperaturen erreicht werden. Vor allem bei dicken Leiterplatten, die sowohl mit großen Bauteilen großer Wärmekapazität als auch mit kleineren Bauteilen und entsprechend kleiner Wärmekapazität bestückt sind, müssen die Temperaturen zur Sicherstellung einer einwandfreien Vorwärmung und Lötung der großen Bauteile häufig so hoch gewählt werden, daß die Gefahr einer Überhitzung der kleineren Bauteile besteht; eine die Überhitzung der kleineren Bauteile ausschließende geringere Temperatur kann demgegenüber zur Folge haben, daß die Vorwärmung der größeren Bauteile ungenügend und die anschließende Lötung unvollkommen ist.

Aus Patent Abstract of Japan, Bd. 14, Nr. 297 (E-945), 27. Juni 1990 und JP-A-2 096 674, 9. April 1990 ist ein Verfahren zum Reflow-Löten von Elektronik-Bauteilen bekannt. Die Bauteile durchlaufen nacheinander eine Vorwärmzone und eine Lötzone. Die Bauteile werden durch ein Transportband in die Lötzone befördert, woraufhin das Transportband anhält. Die Leiterplatte wird aufgeheizt, wobei deren Oberflächentemperatur gemessen wird. Wenn die Schmelztemperatur des Lotes erreicht wird, setzt sich das Transportband in Bewegung und befördert die Bauteile weiter.

Aus Patent Abstract of Japan, Bd. 11, Nr. 64 (M-565), 26. Februar 1987 und JP-A-61 222 674, 3. Oktober 1986 ist eine Einrichtung bekannt, die nicht zum Reflow-Löten dient, sondern zum Durchlauflöten. Die Transportgeschwindigkeit der verschiedenen Vorbehandlungsschritte und der den Lötschritt durchlaufenden Bauteile wird abhängig vom jeweiligen Behandlungsschritt optimal eingestellt. Das Lötergebnis soll dadurch verbessert und die Transportgeschwindigkeit erhöht werden.

Aus der GB-A-2 063 925 ist eine Einrichtung zum Überziehen von Kupferleiterbahnen einer Leiterplatte mit Lot bekannt. Diese Einrichtung hat zwei voneinander unabhängig regelbare Transporteinrichtungen. Mittels der Transportgeschwindigkeit wird die Aufheizzeit der Leiterplatten gesteuert.

Der Erfindung liegt das Problem zugrunde, eine einwandfreie Lötung großer Bauteile ohne Überhitzung der kleinen Bauteile auch bei sich ändernden Umgebungstemperaturen in der Lötzone sicherzustellen.

Diese Aufgabe ist erfindungsgemäß durch die Merkmale des Anspruches 1 bzw. des Anspruches 10 gelöst.

Das erfindungsgemäße Verfahren sieht zunächst grundsätzlich vor, nicht die Heizleistung sondern die Einwirkungszeit durch Einstellung der Transportgeschwindigkeit zu regeln; außerdem sollen die Transportgeschwindigkeiten in der Vorwärmzone einerseits und der Lötzone andererseits unabhängig voneinander einstellbar sein, um eine unabhängige Optimierung in beiden Zonen durchführen zu können.

Dazu wird in der Vorwärmzone eine konstante, nur geringfügig unterhalb der Schmelztemperatur für das Lotmaterial liegende Vorwärmtemperatur vorgegeben, die für alle, d.h. auch die kleineren Bauteile verträglich ist; die Transportgeschwindigkeit in der Vorwärmzone wird so eingestellt, daß die Bauteile mit der größten Wärmekapazität die Vorwärmtemperatur gerade erreichen; dabei ist sichergestellt, daß die Leiterplatte mit allen Bauteilen die höchstmögliche und damit die anschließende Lötzeit weitgehend verkürzende Vorwärmtemperatur erreicht, ohne daß die kleineren Bauteile überhitzt werden, da diese eine über der Vorwärmtemperatur liegende Temperatur nicht annehmen können.

Unabhängig von der Transportgeschwindigkeit in der Vorwärmzone wird in der Lötzone eine Transportgeschwindigkeit gewählt, bei der der Schmelzvorgang des dem Bauteil mit der größten Wärmekapazität zugeordneten Lotmaterials gerade abgeschlossen wird. Da durch das erfindungsgemäße Verfahren sichergestellt ist, daß alle Bauteile eine nur geringfügig unterhalb der Schmelztemperatur liegende Vorwärmtemperatur erreicht haben, kann die Einwirkzeit in der Lötzone äußerst kurz gehalten werden, so daß die kleineren Bauteile auch in der Lötzone nicht überhitzt werden.

Gemäß einer Ausgestaltung der Erfindung wird in der Vorwärmzone die Umgebungstemperatur auf die gewünschte Vorwärmtemperatur eingeregelt. Die Atmosphäre in der Vorwärmzone, die vorzugsweise aus Luft besteht, jedoch auch ein Gasgemisch sein kann, wird beispielsweise mittels Heizkonvektoren auf einen vorgegebenen, konstanten Wert geheizt. Die Erwärmung der Leiterplatte und der Bauteile erfolgt durch Wärmeaustausch zwischen dieser Atmosphäre und den zu erwärmenden Gegenständen.

In weiterer Ausgestaltung der Erfindung ist vorgesehen, daß die Erwärmung der Leiterplatte und der Bauteile auf die Schmelztemperatur des Lotmaterials mittels in der Lötzone angeordneter Heizstrahler erfolgt. Derartige Heizstrahler können bei kleinem Bauvolumen eine große Heizleistung abgeben, so daß die Einwirkungszeit der höheren Temperatur kurz gehalten und die Gefahr einer Schädigung elektronischer Bauteile vermieden werden kann.

Um sicherzustellen, daß nicht durch sich ändernde Umgebungstemperaturen in der Lötzone die Erwärmung der Leiterplatte und der Bauteile verfälscht wird, ist weiter erfindungsgemäß vorgesehen, daß die Umgebungstemperatur in der Lötzone auf eine im Bereich der Schmelztemperatur, vorzugsweise geringfügig unterhalb dieser Schmelztemperatur liegende Höchsttemperatur eingeregelt wird. Dadurch wird erreicht, daß durch die Atmosphäre der Lötzone im wesentlichen nur die in der Vorwärmzone erreichte Vorwärmtemperatur aufrechterhalten, jedoch kein Beitrag zur Erhöhung der Temperatur auf die Schmelztemperatur geleistet wird. Die Regelung der Umgebungstemperatur in der Lötzone erfolgt vorzugsweise durch geregelte Warmluftabsaugung und Frischluftzufuhr.

Um die Vorwärmung der Leiterplatte und der Bauteile zu beschleunigen, ist in weiterer Ausgestaltung der Erfindung vorgesehen, daß die Leiterplatte in zwei Stufen vorgewärmt wird, und zwar zunächst mit einer über der Vorwärmtemperatur liegenden Aufheiztemperatur bis auf einen unterhalb der Vorwärmtemperatur liegenden Wert und sodann mit einer der Vorwärmtemperatur entsprechenden Temperatur auf die vorgegebene Endtemperatur der Vorwärmzone.

Zur Durchführung des Verfahrens ist bei einer Einrichtung mit wenigstens einer Vorwärmzone und einer Lötzone, die jeweils mit Heizeinrichtungen ausgestattet sind, sowie mit einer die Vorwärmzone und die Lötzone nacheinander durchlaufenden Transportanordnung für die Leiterplatten vorgesehen, daß diese Transportanordnung eine der Vorwärmzone zugeordnete erste Transporteinrichtung und eine der Lötzone zugeordnete zweite Transporteinrichtung umfaßt und daß die Transportgeschwindigkeiten dieser beiden Transporteinrichtungen unabhängig voneinander regelbar sind.

Die Vorwärmzone bzw. die Lötzone sind jeweils als weitgehend geschlossene, jeweils mit einer Eintrittsöffnung und einer Austrittsöffnung für die zugeordneten Transporteinrichtungen versehene Kammern ausgebildet, so daß die in den Kammern aufrechterhaltenen Bedingungen sich nicht gegenseitig beeinflussen.

Um in der Lötkammer eine bestimmte Umgebungstemperatur aufrechtzuerhalten, ist diese gemäß einer Ausgestaltung der Erfindung mit einer Einrichtung zur Zwangsentlüftung ausgestattet, die von einem die Mischtemperatur in einer Absaugeinrichtung aufnehmenden Temperaturfühler so angesteuert wird, daß die Umgebungstemperatur in der Lötkammer konstant bleibt.

Weitere Merkmale sowie Vorteile der Erfindung ergeben sich aus den Patentansprüchen und der Beispielsbeschreibung.

Mehrere Ausführungsbeispiele der Erfindung sind in der Zeichnung dargestellt und im folgenden näher beschrieben. Es zeigen:
- Fig. 1: schematisch in einer Seitenansicht eine Einrichtung mit einer Vorwärmkammer und einer Lötkammer, denen jeweils eigene Transportbänder zugeordnet sind;
- Fig. 2: die Anordnung der Fig. 1 in Form eines Blockdiagramms;
- Fig. 3: eine andere Anordnung in Form eines Blockdiagramms;
- Fig. 4: eine weitere Anordnung in Form eines Blockdiagramms;
- Fig. 5: schematisch eine Lötkammer etwa gemäß Fig. 1 mit einer Einrichtung zur Zwangsentlüftung;
- Fig. 6: ein Temperaturdiagramm;

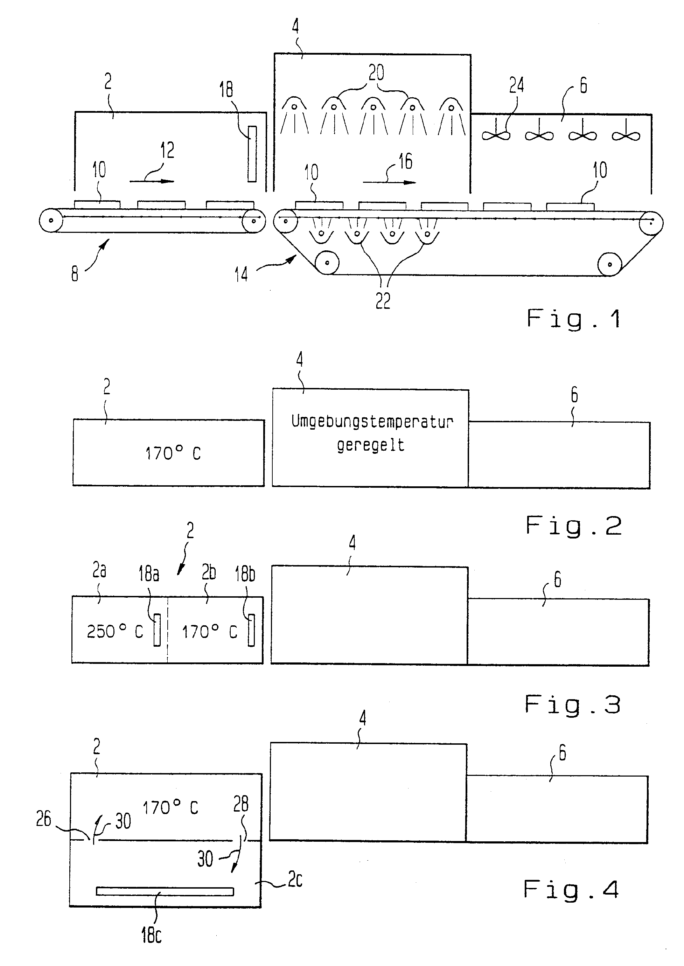

Die in Fig. 1 dargestellte Einrichtung umfaßt eine Vorwärmkammer 2, eine daran anschließende Lötkammer 4 und eine an die Lötkammer 4 anschließende Kühlkammer 6.

Der Vorwärmkammer 2 ist eine als Förderband ausgebildete Transporteinrichtung 8 zugeordnet, mittels der die mit Bauteilen bestückten Leiterplatten 10 in Richtung des Pfeiles 12 durch die Vorwärmkammer 2 transportiert werden.

Der Lötkammer 4 ist ebenfalls eine als Förderband ausgebildete Transporteinrichtung 14 zugeordnet, mittels der die Leiterplatten 10 in Richtung des Pfeiles 16 durch die Lötkammer 4 transportiert werden. Der Anfang der Transporteinrichtung 14 grenzt unmittelbar ans Ende der Transporteinrichtung 8, so daß die Leiterplatten 10 von der Transporteinrichtung 8 an die Transporteinrichtung 14 übergeben werden.

Die Transporteinrichtung 14 ragt an dem der Vorwärmkammer abgewandten Ende der Lötkammer 4 über diese hinaus und erstreckt sich durch die an die Lötkammer 4 anschließende Kühlkammer 6 hindurch.

An dem in Fig. 1 rechten Ende der Transporteinrichtung 14 werden die fertiggelöteten Leiterplatten 10 abgenommen.

In der Vorwärmkammer 2 sind Heizkonvektoren 18, beispielsweise elektrische Widerstandsheizkörper, angeordnet, die die in der Vorwärmkammer befindliche Luft auf eine vorgegebene Vorwärmtemperatur aufheizen, wie genauer anhand der Fig. 2 bis 4 dargelegt wird. Die Vorwärmtemperatur wird durch an sich bekannte, hier nicht näher dargestellte Regelungseinrichtungen konstant gehalten.

In der Lötkammer 4 sind obere Heizstrahler 20 sowie untere Heizstrahler 22 vorgesehen, die beispielsweise als Infrarotstrahler ausgebildet sind. Diese Heizstrahler 20, 22 ermöglichen es, die Leiterplatten 10 mit den auf ihnen befindlichen elektronischen Bauteilen schnell von der geringfügig unter der Schmelztemperatur des Lotmaterials auf diese Schmelztemperatur zu bringen. Damit die von den unteren Heizstrahlern 22 ausgehende Strahlung die Leiterplatten 10 erreichen kann, ist der Boden der Lötkammer 4 beispielsweise als Gitter ausgebildet und die Transporteinrichtung 14 durch mehrere schmale, nebeneinander angeordnete Förderbänder verwirklicht.

In der Kühlkammer 6 sind Ventilatoren 24 angeordnet, welche die aus der Lötkammer 4 austretenden Leiterplatten 10 abkühlen, so daß das die Bauteile mit den Leiterplatten verbindende Lot erstarrt.

Wie weiter vorne bereits ausgeführt wurde und anhand der Fig. 2 nochmals erläutert wird, wird in der Vorwärmkammer 2 eine konstante Umgebungstemperatur aufrechterhalten, die nur geringfügig unter der Schmelztemperatur des Lotmaterials liegt; sie beträgt beispielsweise 170°C. Die Transportgeschwindigkeit der Transporteinrichtung 8 wird so eingeregelt, daß an dem in Fig. 1 rechten Ende der Vorwärmkammer 2 die Bauteile mit der größten Wärmekapazität die Vorwärmtemperatur von 170°C gerade erreicht haben; Bauteile mit geringerer Wärmekapazität erreichen die Vorwärmtemperatur von 170° bereits früher, können aber keine höhere Temperatur als die in der Vorwärmkammer herrschende Vorwärmtemperatur erreichen. Durch diese Anordnung ist sichergestellt, daß die Leiterplatte mit allen Bauteilen die Vorwärmtemperatur erreicht hat, ohne daß einzelne Bauteile überhitzt werden.

Die in der Lötkammer 4 angeordneten Heizstrahler 20, 22 arbeiten mit konstanter Heizleistung, die so bemessen ist, daß an dem in Fig. 1 rechten Ende der Lötkammer 4 bei den vorgesehenen Transportgeschwindigkeiten die Schmelztemperatur für das Lotmaterial des Bauteils mit der größten Wärmekapazität erreicht werden kann. Die Transportgeschwindigkeit der Transporteinrichtung 14 wird je nach Bestückung der Leiterplatten 10 dann jeweils so eingerichtet, daß am Ende der Lötkammer 4 der Schmelzvorgang des dem Bauteil mit der größten Wärmekapazität zugeordneten Lotmaterials gerade abgeschlossen ist.

Die Umgebungstemperatur in der Lötkammer 4 wird durch geeignete Maßnahmen konstant auf einem Wert gehalten, der unterhalb der Schmelztemperatur des Lotmaterials liegt. Auf diese Weise wird sichergestellt, daß die Leiterplatten und die auf diesen befindlichen Bauteile im wesentlichen nur durch die in einfacher Weise in ihrer Heizleistung zu regelnden Heizstrahler 20, 22 erwärmt werden, nicht jedoch zusätzlich durch eine eventuell schwankende Umgebungstemperatur in der Lötkammer 4. Die Umgebungstemperatur in der Lötkammer 4 wird beispielsweise auf 200°C eingeregelt.

In der Kühlkammer 6 werden die Leiterplatten 10 abgekühlt, wobei das Lotmaterial erstarrt und der Lötvorgang abgeschlossen wird. Eine besondere Temperaturregelung in der Kühlkammer 6 ist nicht erforderlich.

Fig. 3 zeigt eine Anordnung etwa gemäß Fig. 2, wobei jedoch die Vorwärmkammer 2 in einen Aufheizbereich 2a mit einer Umgebungstemperatur von beispielsweise 250°C und einen daran anschließenden Bereich 2b aufgeteilt ist, in welchem die vorgegebene Vorwärmtemperatur von 170°C herrscht. In dem Aufheizbereich 2a wird die Leiterplatte schnell an die Vorwärmtemperatur herangeführt, in dem anschließenden Bereich 2b dann endgültig auf die Vorwärmtemperatur gebracht. Auf diese Weise kann der Vorwärmvorgang beschleunigt werden, so daß die Transporteinrichtung 8 mit einer höheren Geschwindigkeit betrieben werden kann. In den Bereichen 2a bzw. 2b sind jeweils getrennte Heizkonvektoren 18a bzw. 18b angeordnet.

Fig. 4 zeigt eine Anordnung, bei welcher unterhalb der Vorwärmkammer 2 eine Heizkammer 2c angeordnet ist, in der die Heizkonvektoren 18c untergebracht sind. Die Heizkammer 2c ist über Luftdurchtrittsöffnungen 26 bzw. 28 mit der Vorwärmkammer 2 verbunden, so daß aufgeheizte Luft entsprechend den Pfeilen 30 von der Heizkammer 2c zur Vorwärmkammer 2 und wieder zurück strömen kann. Damit wird vermieden, daß von den Heizkonvektoren 18c ausgehende Wärmestrahlung auf die Leiterplatten bzw. die auf diesen befindlichen Bauteile auftrifft und die Erwärmung in der Vorwärmkammer 2 verfälscht.

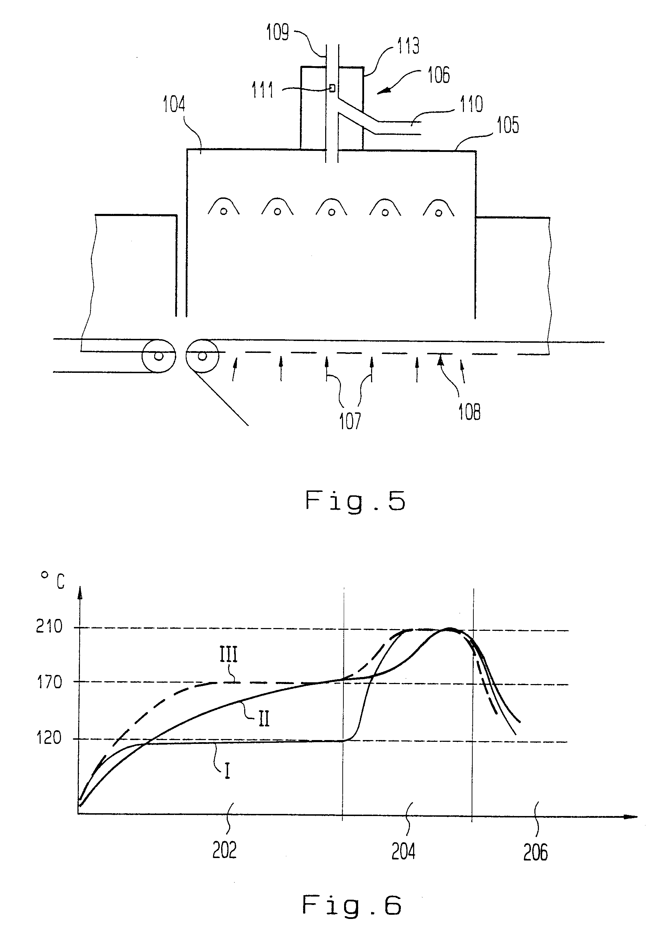

Fig. 5 zeigt eine Lötkammer 104 etwa entsprechend der Lötkammer 4 in Fig. 1. Um die Umgebungstemperatur in der Lötkammer 104, die durch die Wärmeabstrahlung der in der Lötkammer 104 befindlichen Gegenstände, beispielsweise Leiterplatten und elektronische Bauteile, beeinflußt wird, konstant zu halten, ist an der Deckenwand 105 der Lötkammer 104 eine Warmluftabsaugung 106 vorgesehen, durch die in der Lötkammer 104 befindliche Warmluft abgesaugt werden kann. Die abgesaugte Warmluft wird durch Frischluft 107 ersetzt, die durch die beispielsweise als Gitter aufgebaute Bodenwand 108 nachströmen kann. Die Warmluftabsaugung 106 besteht aus einem Absaugrohr 109 und einem in dieses mündenden Ejektorrohr 110, durch das Druckluft in das Absaugrohr eingeblasen wird, so daß durch einen Ejektoreffekt Warmluft durch das Absaugrohr 109 abgesaugt wird. Die Absaugregelung wird durch einen Temperaturfühler 111 gesteuert, welcher im Abluftstrom angeordnet ist. Mit 113 ist ein das Absaugrohr 109 umgebender Schutzmantel bezeichnet.

Fig. 6 zeigt ein Diagramm, auf dessen Ordinate die Temperatur und auf dessen Abszisse der Weg der Leiterplatten durch die Vorwärmzone, die Lötzone und die Kühlzone dargestellt ist. Die Vorwärmzone 202 entspricht der Vorwärmkammer 201; die Lötzone 204 entspricht der Lötkammer 4 und die Kühlzone 206 der Kühlkammer 6 in Fig. 1.

Die Kurve I beschreibt den Temperaturverlauf eines Bauteils großer Wärmekapazität in einer herkömmlichen Einrichtung, bei der die Leiterplatten durch eine Transporteinrichtung mit für alle Kammern gleicher, nicht individuell regelbarer Geschwindigkeit transportiert werden. Da die Abstimmung der in den Kammern zu erzeugenden Temperaturen damit schwierig ist, werden die Leiterplatten mit den Bauteilen in der Vorwärmzone auf eine verhältnismäßig geringe Vorwärmtemperatur erwärmt und in der Lötzone auf die Schmelztemperatur des Lotmaterials aufgeheizt. Vor allem wenn Bauteile unterschiedlicher Wärmekapazität auf der Leiterplatte angeordnet sind, ist nicht sichergestellt, daß alle Bauteile die gleiche Vorwärmtemperatur annehmen; in der Lötzone 204 ist dann ein steiler, großer Temperaturanstieg erforderlich, wobei die Gefahr besteht, daß unterschiedlich vorgewärmte Bauteile entweder überhitzt oder unvollkommen gelötet werden.

Die Kurve II zeigt den Temperaturverlauf in einer erfindungsgemäßen Einrichtung für Bauteile großer Wärmekapazität. Die Transportgeschwindigkeit in der Vorwärmzone 202 wird so eingestellt, daß die Bauteile großer Wärmekapazität am Ende der Vorwärmzone 202 eine hohe, nur wenig unter der Löttemperatur liegende Vorwärmtemperatur von 170°C gerade erreichen; Bauteile kleinerer Wärmekapazität, deren Temperaturverlauf durch die Kurve III dargestellt wird, erreichen die Vorwärmtemperatur von 170°C bereits früher, können diese jedoch nicht übersteigen.

In der Lötzone 204 wird die Transportgeschwindigkeit der Transporteinrichtung wiederum so eingestellt, daß der Schmelzvorgang des den Bauteilen großer Wärmekapazität zugeordneten Lotmaterials entsprechend der Kurve II am Ende der Lötzone 204 gerade abgeschlossen ist; die Bauteile kleinerer Wärmekapazität erreichen die entsprechende Temperatur schon früher, wie die Kurve III zeigt, werden jedoch durch die kurze Einwirkungszeit der Heizstrahler nicht oder kaum über diese Temperatur erhitzt.

## Patentansprüche

1. Verfahren zum Reflow-Löten von Elektronik-Bauteilen auf eine Leiterplatte (10), wobei die die Bauteile tragende Leiterplatte (10) zuerst durch wenigstens eine Vorwärmzone (202) mit einer konstanten Vorwärmtemperatur hindurch und anschließend durch eine Lötzone (204) transportiert wird, in der das Lot geschmolzen wird, dadurch **gekennzeichnet**, daß mittels einer ersten Transporteinrichtung (8) die Transportgeschwindigkeit in der Vorwärmzone (202) so eingestellt wird, daß am Ende der Vorwärmzone (202) das Bauteil mit der größten Wärmekapazität die Vorwärmtemperatur gerade erreicht hat, daß mittels einer zweiten Transporteinrichtung (14) die Transportgeschwindigkeit in der Lötzone (204) so eingestellt wird, daß am Ende der Lötzone (204) der Schmelzvorgang des dem Bauteil mit der größten Wärmekapazität zugeordneten Lotes gerade abgeschlossen ist, wobei die Transportgeschwindigkeiten der beiden Transporteinrichtungen (8, 14) unabhängig voneinander geregelt werden und die Umgebungstemperatur in der Lötzone (204) auf eine geringfügig unterhalb der Schmelztemperatur liegende Höchsttemperatur einregelt wird.

2. Verfahren nach Anspruch 1, dadurch **gekennzeichnet,** daß daß die Vorwärmtemperatur auf eine unterhalb, jedoch nahe an der Schmelztemperatur des Lotmaterials liegende Temperatur eingeregelt wird.

3. Verfahren nach Anspruch 1 oder 2, dadurch **gekennzeichnet,** daß die Umgebungstemperatur in der Vorwärmzone (202) auf die Vorwärmtemperatur eingeregelt wird.

4. Verfahren nach Anspruch 3, dadurch **gekennzeichnet,** daß die Vorwärmtemperatur mittels Heizkonvektoren (18) erzeugt wird.

5. Verfahren nach einem der Ansprüche 1 bis 4, dadurch **gekennzeichnet,** daß die Schmelztemperatur mittels auf die Leiterplatte (10) und/oder die Bauteile gerichteter Heizstrahler (20, 22) erzeugt wird.

6. Verfahren nach einem der Ansprüche 1 bis 5, dadurch **gekennzeichnet,** daß die Umgebungstemperatur in der Lötzone (204) durch geregelte Warmluftabsaugung und Frischluftzufuhr geregelt wird.

7. Verfahren nach einem der Ansprüche 1 bis 6, dadurch ge**kennzeichnet,** daß die Vorwärmtemperatur im Bereich von 170°C gehalten wird.

8. Verfahren nach Anspruch 6 oder 7, dadurch **gekennzeichnet,** daß die Mischtemperatur im Absaugebereich der Lötzone (204) auf 200°C gehalten wird.

9. Verfahren nach einem der Ansprüche 1 bis 8, dadurch **gekennzeichnet,** daß die Leiterplatte (10) in einem ersten Vorwärmbereich (2a) der Vorwärmzone mit einer über der vorgegebenen Vorwärmtemperatur liegenden Aufheiztemperatur schnell auf eine unterhalb der Vorwärmtemperatur liegende Temperatur erwärmt und in einem in Transportrichtung anschließenden zweiten Vorwärmbereich (2b) mit einer der Vorwärmtemperatur entsprechenden Temperatur fertig erwärmt wird.

10. Einrichtung zur Durchführung des Verfahrens nach einem der Ansprüche 1 bis 9, mit wenigstens einer Vorwärmzone (2, 202) und einer Lötzone (4, 204), denen jeweils Heizeinrichtungen (18, 20, 22) zugeordnet sind, und mit einem die Vorwärmzone (2, 202) und die Lötzone (4, 204) nacheinander durchlaufenden Transportanordnung für die Leiterplatten, dadurch **gekennzeichnet,** daß eine erste Transporteinrichtung (8) vorgesehen ist, die die Transportgeschwindigkeit in der Vorwärmzone (202) so einstellt, daß am Ende der Vorwärmzone (202) das Bauteil mit der größten Wärmekapazität die Vorwärmtemperatur gerade erreicht, daß eine zweite Transporteinrichtung (14) vorgesehen ist, die die Transportgeschwindigkeit in der Lötzone (204) so einstellt, daß am Ende der Lötzone (204) der Schmelzvorgang des dem Bauteil mit der größten Wärmekapazität zugeordneten Lotes gerade abgeschlossen ist, wobei die Transportgeschwindigkeiten der beiden Transporteinrichtungen (8, 14) unabhängig voneinander regelbar sind und daß Mittel (106, 109, 110, 111) vorgesehen sind, die die Umgebungstemperatur in der Lötzone (204) auf eine geringfügig unterhalb der Schmelztemperatur liegende Höchsttemperatur einregeln.

11. Einrichtung nach Anspruch 10, dadurch **gekennzeichnet,** daß die Vorwärmzone ((202) bzw. die Lötzone (204) als weitgehend geschlossene, jeweils mit einer Eintrittsöffnung und einer Austrittsöffnung für die zugeordneten Transporteinrichtungen (8, 14) versehene Kammern (2, 4) ausgebildet sind.

12. Einrichtung nach Anspruch 11, dadurch **gekennzeichnet,** daß der Vorwärmkammer (2) Heizkonvektoren (18), vorzugsweise elektrische Widerstandsheizkörper zugeordnet sind.

13. Einrichtung nach Anspruch 12, dadurch **gekennzeichnet**, daß die Vorwärmkammer (2) zwei in Transportrichtung hintereinander angeordnete Bereiche (2a, 2b) umfaßt, deren erster (2a) auf eine über der Vorwärmtemperatur liegende Aufheiztemperatur und deren zweiter (2b) auf die Vorwärmtemperatur einregelbar ist.

14. Einrichtung nach Anspruch 12 oder 13, dadurch **gekenn**zeichnet, daß der Vorwärmkammer (2) ein über Luftleitöffnungen (26, 28) mit dieser verbundender Heizraum (2c) zugeordnet ist, in welchem die Heizkonvektoren (18c) angeordnet sind.

15. Einrichtung nach einem der Ansprüche 11 bis 14, dadurch **gekennzeichnet,** daß die Lötkammer (4) mit Heizstrahlern (20, 22), vorzugsweise IR-Strahlern ausgestattet ist.

16. Einrichtung nach einem der Ansprüche 11 bis 15, dadurch gekennzeichnet, daß die Lötkammer (4) mit einer Einrichtung (106) zur Zwangsentlüftung ausgestattet ist.

17. Einrichtung nach Anspruch 16, dadurch **gekennzeichnet**, daß die Einrichtung (106) zur Zwangsentlüftung von einem die Umgebungstemperatur in der Lötkammer (4) aufnehmenden Temperaturfühler (111) angesteuert wird.

18. Einrichtung nach Anspruch 16 oder 17, dadurch **gekennzeichnet,** daß die Einrichtung (106) zur Zwangsentlüftung einen Absaugejektor (109, 110) sowie in der Lötkammerwand (108) ausgebildete Zuströmöffnungen umfaßt.

19. Einrichtung nach einem der Ansprüche 10 bis 18, dadurch **gekennzeichnet,** daß die erste (8) und zweite (14) Transporteinrichtung jeweils eine Förderbandanordnung zur Aufnahme der Leiterplatten (10) ist.

20. Einrichtung nach einem der Ansprüche 10 bis 19, dadurch **gekennzeichnet,** daß sich an die Lötkammer (4) in Durchlaufrichtung der zweiten Transporteinrichtung (14) eine Kühlkammer (6) anschließt und daß die zweite Transporteinrichtung (14) auch die Kühlkammer (6) durchläuft.

## Claims

1. Method of reflow soldering of electronic components onto a printed circuit board (10), the printed circuit board (10) carrying the components being transported at first through at least one preheating zone (202) having a constant preheating temperature and subsequently through a soldering zone (204) in which the solder is melted, characterized in that by means of a first transport device (8) the transport speed in the preheating zone (202) is set in such a manner that at the end of the preheating zone (202) the component having the greatest heat capacity has just reached the preheating temperature, in that by means of a second transport device (14) the transport speed in the soldering zone (204) is set in such a manner that at the end of the soldering zone (204) the melting process of the solder assigned to the component having the greatest heat capacity is just terminated, the transport speeds of the two transport devices (8, 14) being controlled independently of each other and the ambient temperature in the soldering zone (204) being controlled to a maximum temperature which is slightly below the melting temperature.

2. Method according to Claim 1, characterized in that the preheating temperature is controlled to a temperature which is below, but close to, the melting temperature of the solder material.

3. Method according to Claim 1 or 2, characterized in that the ambient temperature in the preheating zone (202) is controlled to the preheating temperature.

4. Method according to Claim 3, characterized in that the preheating temperature is produced by means of heating convectors (18).

5. Method according to one of Claims 1 to 4, characterized in that the melting temperature is produced by means of radiant heaters (20, 22) directed at the printed circuit board (10) and/or the components.

6. Method according to one of Claims 1 to 5, characterized in that the ambient temperature in the soldering zone (204) is controlled by controlled hot-air suction and fresh-air supply.

7. Method according to one of Claims 1 to 6, characterized in that the preheating temperature is kept in the region of 170°C.

8. Method according to Claim 6 or 7, characterized in that the mixing temperature in the suction region of the soldering zone (204) is kept at 200°C.

9. Method according to one of Claims 1 to 8, characterized in that the printed circuit board (10) is heated rapidly, at a heating-up temperature which is above the predetermined preheating temperature, in a first preheating region (2a) of the preheating zone to a temperature which is below the preheating temperature and the heating of the printed circuit board (10) is completed, in a second preheating region (2b) which adjoins in the transport direction, at a temperature which corresponds to the preheating temperature.

10. Device for carrying out the method according to one of Claims 1 to 9, having at least one preheating zone (2, 202) and a soldering zone (4, 204) which are assigned in each case heating devices (18, 20, 22), and having a transport arrangement, running through the preheating zone (2, 202) and the soldering zone (4, 204), for the printed circuit boards, characterized in that a first transport device (8) is provided which sets the transport speed in the preheating zone (202) in such a manner that at the end of the preheating zone (202) the component having the largest heat capacity just reaches the preheating temperature, that a second transport device (14) is provided which sets the transport speed in the soldering zone (204) in such a manner that at the end of the soldering zone (204) the melting process of the solder assigned to the component having the largest heat capacity is just terminated, the transport speeds of the two transport devices (8, 14) being controllable independently of each other and that means (106, 109, 110, 111) are provided which control the ambient temperature in the soldering zone (204) to a maximum temperature which is slightly below the melting temperature.

11. Device according to Claim 10, characterized in that the preheating zone (202) or the soldering zone (204) are constructed as largely closed chambers (2, 4) which are provided in each case with an inlet opening and an outlet opening for the assigned transport devices (8, 14).

12. Device according to Claim 11, characterized in that the preheating chamber (2) is assigned heating convectors (18), preferably electrical resistance heaters.

13. Device according to Claim 12, characterized in that the preheating chamber (2) comprises two regions (2a, 2b) which are arranged one behind the other in the transport direction and the first (2a) of which can be controlled to a heating-up temperature which is above the preheating temperature and the second (2b) of which can be controlled to the preheating temperature.

14. Device according to Claim 12 or 13, characterized in that the preheating chamber (2) is assigned a heating space (2c) which is connected to the preheating chamber (2) via air-ducting openings (26, 28) and in which the heating convectors (18c) are arranged.

15. Device according to one of Claims 11 to 14, characterized in that the soldering chamber (4) is equipped with radiant heaters (20, 22), preferably infrared radiators.

16. Device according to one of Claims 11 to 15, characterized in that the soldering chamber (4) is equipped with a device (106) for forced ventilation.

17. Device according to Claim 16, characterized in that the device (106) for forced ventilation is driven by a temperature sensor (111) which picks up the ambient temperature in the soldering chamber (4).

18. Device according to Claim 16 or 17, characterized in that the device (106) for forced ventilation comprises a suction ejector (109, 110) and influx openings formed in the soldering-chamber wall (108).

19. Device according to one of Claims 10 to 18, characterized in that the first (8) and second (14) transport device is in each case a conveyor-belt arrangement for receiving the printed circuit boards (10).

20. Device according to one of Claims 10 to 19, characterized in that the soldering chamber (4) is adjoined in the travel direction of the second transport device (14) by a cooling chamber (6) and in that the second transport device (14) travels also through the cooling chamber (6).

## Revendications

1. Procédé pour le brasage par fusion de composants électroniques sur une plaquette à circuits imprimés (10), la plaquette à circuits imprimés (10), qui porte les composants, étant tout d'abord déplacée dans au moins une zone de préchauffage (202) à une température de préchauffage constante, puis dans une zone de brasage (204), dans laquelle la brasure est fondue, caractérisé en ce qu'à l'aide d'un premier dispositif de convoyage (8), on règle la vitesse de convoyage dans la zone de préchauffage (202) de manière qu'à l'extrémité de la zone de préchauffage (202), le composant ayant la capacité calorifique la plus grande atteigne juste la température de préchauffage, qu'à l'aide d'un second dispositif de convoyage (4), on règle la vitesse de convoyage dans la zone de brasage (204) de manière qu'à l'extrémité de la zone de brasage (204), le processus de fusion de la brasure associée au composant ayant la capacité calorifique la plus grande soit juste terminé, les vitesses de convoyage des deux dispositifs de convoyage (8,14) étant réglées indépendamment l'une de l'autre et la température ambiante dans la zone de brasage (204) étant réglée à une température maximale légèrement inférieure à la température de fusion.

2. Procédé suivant la revendication 1, caractérisé par le fait que la température de préchauffage est réglée sur une température inférieure, mais proche de la température de fusion de la brasure.

3. Procédé suivant la revendication 1 ou 2, caractérisé par le fait que la température ambiante dans la zone de préchauffage (202) est réglée à la température de préchauffage.

4. Procédé suivant la revendication 3, caractérisé par le fait que la température de préchauffage est produite à l'aide de convecteurs de chaleur (18).

5. Procédé suivant l'une des revendications 1 à 4, caractérisé par le fait que la température de fusion est produite au moyen de radiateurs chauffants (20,21) dirigés sur la plaquette à circuits imprimés (10) et/ou sur les composants.

6. Procédé suivant l'une des revendications 1 à 5, caractérisé par le fait que la température ambiante dans la zone de brasage (204) est réglée au moyen d'une aspiration réglée d'air de chauffage et d'un apport réglé d'air frais.

7. Procédé suivant l'une des revendications 1 à 6, caractérisé par le fait que la température de préchauffage est maintenue au voisinage de 170°C.

8. Procédé suivant la revendication 6 ou 7, caractérisé par le fait que la température de mélange dans la zone d'aspiration et la zone de brasage (204) est maintenue à 200°C.

9. Procédé suivant l'une des revendications 1 à 8, caractérisé par le fait que dans une première région de préchauffage (2a) de la zone de préchauffage, la plaquette à circuits imprimés (10) est chauffée rapidement, avec une température de chauffage supérieure à la température de préchauffage prédéterminée, à une température inférieure à la température de préchauffage, et subit un chauffage final dans une seconde région de préchauffage (2b), qui se raccorde à la première dans la direction de convoyage, avec une température qui correspond à la température de préchauffage.

10. Procédé suivant l'une des revendications 1 à 9, comportant au moins une zone de préchauffage (2,202) et une zone de brasage (4,204), auxquelles sont associés des dispositifs de chauffage respectifs (18,20,22), et un dispositif de convoyage, qui passe successivement dans la zone de préchauffage (2,202) et dans la zone de brasage (4,204), des plaquettes à circuits imprimés, caractérisé par le fait qu'il est prévu un premier dispositif de convoyage (8), qui règle la vitesse de convoyage dans la zone de préchauffage (202) de telle sorte qu'à l'extrémité de cette zone de préchauffage, le composant ayant la capacité thermique la plus grande atteint juste la température de préchauffage, qu'il est prévu un second dispositif de convoyage (14), qui règle la vitesse de convoyage dans la zone de brasage (204) de telle sorte qu'à l'extrémité de la zone de brasage (204), le processus de fusion de la brasure, qui est associée au composant ayant la capacité calorifique la plus grande, est juste terminé, les vitesses de transport des deux dispositifs de convoyage (8,14) étant réglables indépendamment l'une de l'autre, et qu'il est prévu des moyens (106,109,110,111), qui règlent la température ambiante dans la zone de brasage (204) à une température maximale légèrement inférieure à la température de fusion.

11. Procédé suivant la revendication 10, caractérisé par le fait que la zone de préchauffage (202) et la zone de brasage (204) sont agencées sous la forme de chambres (2,4) qui sont dans une large mesure fermées et sont pourvues chacune d'une ouverture d'entrée et d'une ouverture de sortie pour les dispositifs de convoyage associés (8,14).

12. Procédé suivant la revendication 11, caractérisé par le fait que des convecteurs de chaleur (18), de préférence des corps chauffants à résistance électrique, sont associés à la chambre de préchauffage (2).

13. Procédé suivant la revendication 12, caractérisé par le fait que la chambre de préchauffage (2) comprend deux régions (2a,2b), qui sont disposées l'une derrière l'autre dans la direction de convoyage et dont la première (2a) peut être réglée à une température de chauffage supérieure à la température de préchauffage et dont la seconde (2b) peut être réglée à la température de préchauffage.

14. Procédé suivant la revendication 12 ou 13, caractérisé par le fait que la chambre de préchauffage (2) est associée à un espace de chauffage (2c), qui communique avec cette chambre par des ouvertures de passage d'air (26,28) et dans lequel sont disposés les convecteurs de chaleur (18c).

15. Procédé suivant l'une des revendications 11 à 14, caractérisé par le fait que la chambre de brasage (4) est équipée de radiateurs chauffants (20,22), de préférence des radiateurs à infrarouge.

16. Dispositif suivant l'une des revendications 11 à 15, caractérisé par le fait que la chambre de brasage (4) est équipée d'un dispositif de désaération forcée (106).

17. Dispositif suivant la revendication 16, caractérisé par le fait que le dispositif de désaération forcée (106) est commandé par un capteur de température (106) qui détecte la température ambiante dans la chambre de brasage (4).

18. Dispositif suivant la revendication 16 ou 17, caractérisé par le fait que le dispositif de désaération forcée (106) comprend un éjecteur (109,110) ainsi que des ouvertures d'alimentation, formées dans la paroi (108) de la chambre de brasage.

19. Dispositif suivant l'une des revendications 10 à 18, caractérisé par le fait que le premier dispositif de convoyage (8) et le second dispositif de convoyage (14) sont constitués chacun par un dispositif en forme de bande convoyeuse destiné à recevoir des plaquettes à circuits imprimés (10).

20. Dispositif suivant l'une des revendications 10 à 19, caractérisé par le fait qu'une chambre de refroidissement (6) se raccorde à la chambre de brasage (4) dans la direction de convoyage du second dispositif de convoyage (14) et que ce second dispositif de convoyage (14) passe également dans la chambre de refroidissement (6).
